Europäisches Patentamt

European Patent Office

Office européen des brevets

(19)

(11) Publication number: **0 161 947 B1**

# EUROPEAN PATENT SPECIFICATION

(45) Date of publication of patent specification: **31.07.91**

(51) Int. Cl.5: **G11C 17/00, G11C 17/16**

(21) Application number: **85400383.7**

(22) Date of filing: **28.02.85**

(54) Integrated circuit having a fuse circuit.

(30) Priority: **29.02.84 JP 37927/84**

(43) Date of publication of application:
**21.11.85 Bulletin 85/47**

(45) Publication of the grant of the patent:
**31.07.91 Bulletin 91/31**

(84) Designated Contracting States:
**DE FR GB**

(56) References cited:
**US-A- 4 329 685**

**IBM TECHNICAL DISCLOSURE BULLETIN, vol. 15, no. 8, January 1973, pages 2371-2372, New York, US; P.W. COOK et al.: "Read-only memory fabrication by laser formed connections"**

(73) Proprietor: **FUJITSU LIMITED**
**1015, Kamikodanaka Nakahara-ku**
**Kawasaki-shi Kanagawa 211(JP)**

(72) Inventor: **Kunitoki, Tadayoshi**
**23-10, Umegaoka Midori-Ku**
**Yokohama-shi Kanagawa 227(JP)**
Inventor: **Gotoh, Kunihiko**
**46-2-3-403, Fujimidai 2-chome**
**Kunitachi-shi Tokyo 186(JP)**

(74) Representative: **Descourtieux, Philippe et al**
**CABINET BEAU de LOMENIE 55 rue d'Amsterdam**
**F-75008 Paris(FR)**

## Description

### BACKGROUND OF THE INVENTION

This invention relates to an integrated circuit having a fuse circuit, and in particular, to a fuse circuit which enables the detection as to whether or not the fuse has been blown out.

Integrated circuits (IC) having fuse circuits are becoming more and more widely used. It is well known that the characteristics of ICs show some fluctuations due to the fabrication process. Such fluctuations are particularly detrimental in the case, for example, of IC having a built-in reference voltage. In order to correct such malfunctions, it is known to subject IC chips to a trimming process. Chip trimming is often performed by means of fuse circuits. For example, the circuit is connected to a D/A converter circuit, to control precisely its reference voltage by means of the fuse circuit, the gain between the input and output signal being adjusted by blowing the fuse by applying a high current thereto.

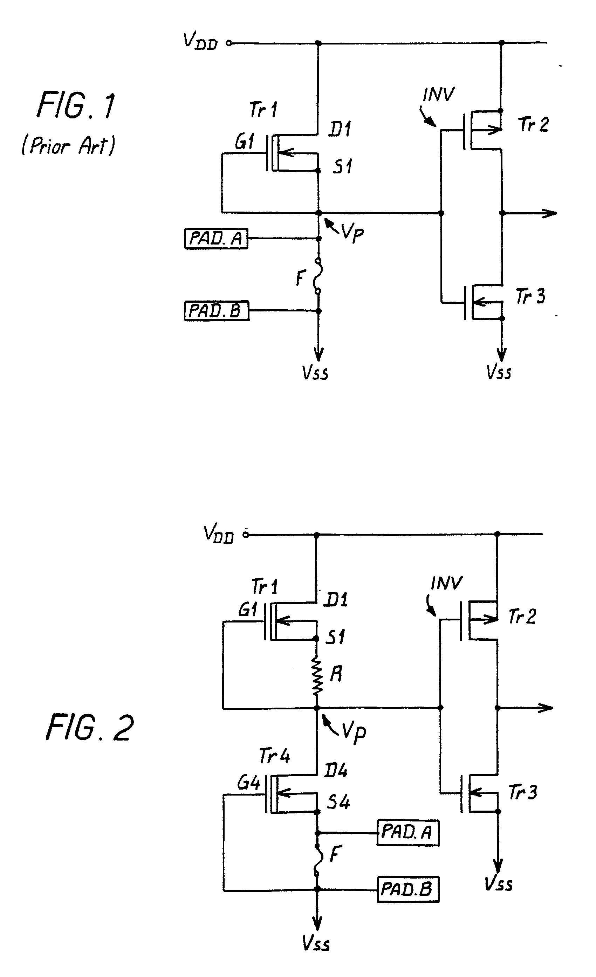

Fig. 1 is a conventional fuse circuit for use in a trimming process. A field effect transistor (FET) Tr1 of n-channel depletion type constitutes a constant current source with its gate electrode G1 connected to its source S1. A fuse circuit is formed by the FET Tr1 and a fuse F, which are connected in series between a positive voltage source $V_{DD}$ and a negative voltage source $V_{SS}$. The junction point of the source S1 of the FET Tr1 with the fuse F is connected to an input terminal of an inverter INV for detecting whether the fuse is blown or not. The inverter INV is formed of complementary metal oxide semiconductor (CMOS) transistors including an enhancement type p-MOS transistor Tr2 and a n-channel MOS transistor Tr3.

The fuse F is blown by applying a high current at pads PAD.A and PAD.B respectively connected to the fuse terminals. Judging whether the fuse F has been blown or not is done by checking whether the on-state resistance of the FET Tr1 is larger or smaller than the resistance $R_F$ of the fuse F. Namely, when the fuse F is in the blown state a "judging" potential Vp at the junction point between S1 and F rises up to a high potential level "H", and it is applied to the input of the inverter INV. The output of the inverter INV comes then to a low potential level "L". Conversely, if the fuse F has not been blown, the judging potential Vp is at the potential of the negative voltage source Vss, this being the low potential level "L". Then the output of the inverter INV is at the high potential level "H".

Generally, in such a conventional fuse circuit, in order to decrease the power dissipation of the fuse circuit, the on-state resistance of the FET Tr1 is designed to be larger than that of the fuse F. For example, the fuse F has usually a small resistance of about 100 ohms when it is in the unblown state, but the internal resistance between the drain D1 and the source S1 of the FET Tr1 is of about a few M-ohms.

After the fuse has been blown, some leakage may occasionally, occur through the gap between the fuse terminals. This leads to what is called a "re-grown fuse" or "grown-back fuse". A change of the resistance $R_F$ between the fuse terminals is caused by moisture or contamination of gap of the fuse terminals. For example, when the resistance $R_F$ is decreased from 3 Mohms to 2 M-ohms due to the "grown-back fuse" effect, the input of the inverter INV is changed from the high potential level "H" to low potential level "L". The fuse condition is not correctly sensed, and the trimming circuit is out of control.

### SUMMARY OF THE INVENTION

It is an object of the present invention to provide a fuse circuit which does not lead to an erroneous detection of the fuse condition in the case of insufficient fuse blowing ("grown-back fuse" or "regrown-fuse" state), whereby it can be accurately judged whether the fuse has been blown or not.

It is therefore another object of the present invention to provide a fuse circuit which generates a judging potential corresponding exactly to the fuse condition.

It is still another object of the present invention to provide a fuse circuit to detect whether a fuse has blown or not by judging whether the fuse resistance is larger or smaller compared with a predetermined threshold resistor.

The foregoing objects are attained by an integrated circuit having a fuse (F) and an impedance element means (Tr1), serially connected between first and second power supply means for supplying respectively a first voltage ($V_{DD}$) and a second voltage ($V_{SS}$) and providing at a point between the fuse (F) and the impedance element means (Tr1) a judging potential ($V_p$) for judging whether the fuse (F) has blown or not, characterized by a first transistor (Tr4) realising the connection between said fuse (F) and said point supplying said judging potential ($V_p$) and having a source connected to said fuse (F) and a drain connected to said point supplying said judging potential ($V_p$); and a gate biased so that a potential difference between the source and the gate is dependent on a voltage drop across the fuse (F) when the fuse (F) is in a grown-back fuse condition.

In one embodiment of the invention, the impedance element means comprises a second transistor having a constant current characteristic and a predetermined threshold resistor. The threshold resistor may be designed to have a resistance larger than that of the fuse in the unblown state, but smaller than that of the grown-back fuse in the blown state.

In another embodiment of the invention, the impedance element means is formed by a second transistor having a saturation current lower than that of the first transistor, and having a ratio w/L smaller than that of the first transistor, where W and L are respectively the channel width and the channel length of the gate electrode of the transistors.

The details and advantages of the present invention will be more apparent from the following description made with reference to the accompanying drawings, wherein :

Fig. 1 is a circuit diagram of a prior art fuse circuit;

Fig. 2 is a diagram of an embodiment of a fuse circuit according to the present invention;

Fig. 3 is a diagram of another embodiment of a fuse circuit according to the present invention;

Figs. 4A and 4B are exemplary plan views of patterns of the transistors used in the circuit of Fig. 3, the pattern of 4A providing a higher on-state resistance compared to the pattern of Fig. 4B;

Fig. 5A is a graph showing the voltage-current characteristics of a FET of the circuit of Fig. 1 and lines representative of different fuse resistances corresponding to different respective fuse conditions;

Fig. 5B is a graph showing the voltage-current characteristic of a FET of the circuit of Fig. 3 and lines representative of different fuse resistances corresponding to different respective fuse conditions;

Fig. 6A is a graph showing the voltage-current characteristics respectively of a first and a second FET in the circuit of Fig. 3;

Fig. 6B is a graph illustrating the stability of operation of the circuit corresponding to the present invention; and

Fig. 7A and Fig. 7B are diagrams of still another embodiment of a fuse circuit according to the present invention applied to a CMOS circuit.

Same or like reference numerals denote same or like parts throughout the drawings.

## DETAILED DESCRIPTION OF PREFERRED EMBODIMENT

Fig. 2 shows an embodiment of a fuse circuit according to the present invention. In order to obtain constant current characteristics, an impedance element in the form of a first n-channel depletion field effect transistor (FET) Tr1 is provided with a predetermined threshold resistor R connected between its gate G1 and source S1. Similarly, a second FET Tr4 is provided with a fuse F between its gate G4 and source S4. The FETs Tr1 and Tr4 are connected in series between a positive voltage $V_{DD}$ and a negative voltage or ground voltage $V_{SS}$ provided by respective first and second power supply means, the drain D1 of the FET Tr1 being connected to the positive voltage supply means. The junction point between the gate G1 of the first FET Tr1 and the drain D4 of the second FET Tr4 is connected to an input of an inverter INV to detect whether the fuse has blown or not. The inverter INV is composed of complementary metal oxide semiconductor (CMOS) transistors including an enhancement type p-channel MOS transistor Tr2 and a n-channel MOS transistor Tr3.

In the impedance element including the first FET Tr1 and the threshold resistor R, the resistance of transistor R is selected to a few Kilo-ohms, this value being determined from the value of resistance for which the fuse is judged to be blown or not. The value of this resistance is not critical. The FETs Tr1 and Tr4 are designed to have the same size and are fabricated on a same chip together with the threshold resistor R and the fuse F, the fabrication method consisting in a conventional IC fabrication process.

The circuit of Fig. 2 functions as follows. The gate voltage $V_{G1}$ of the FET Tr1 is decreased by the resistor R, and the FET Tr1 is used as a resistor equivalent. Similarly, the gate voltage $V_{G4}$ of the FET Tr4 is also decreased by resistance of the fuse F, and the second FET Tr4 is also used as a resistor equivalent. Therefore, when the voltages $V_{DD}$ and $V_{SS}$ are applied to the serial circuit of Tr1, R, Tr4 and F, a divided voltage Vp appears at the junction point between the gate G1 of the first FET Tr1 and the drain D4 of the second FET Tr4. The divided voltage Vp is proportional to the ratio of the equivalent resistance of the FET Tr1 to that of the FET Tr4. As a result, the divided voltage Vp is varied as a function of the fuse condition, namely whether the fuse has been blown or not. The divided voltage Vp is applied to an input terminal of the inverter INV, as shown in Fig. 2, so that it can be judged whether the fuse is blown or not. Therefore, the potential of the divided voltage Vp is also called "judging potential Vp".

Generally, when the fuse F is not blown and in conductive state it has a small resistance of about 100 ohms, but when the fuse has blown, it has very high resistance, in the order of many meg-ohms. In Fig. 2, the judging potential Vp is mainly determined by the ratio of the equivalent resistance $R_1$ of the FET Tr1 to the equivalent resistor $R_4$ of the FET Tr4. For example, when the equivalent resis-

tance $R_1$ is equal to the resistance $R_4$, and also the threshold resistor R is equal to the resistance $R_F$ of the fuse F, the judging potential Vp is equal to $(V_{DD}-V_{SS})/2$. Thus, when the fuse resistance $R_F$ becomes larger than the resistor R, the judging potential Vp reaches a high potential level "H". Similarly, when the fuse resistance $R_F$ is smaller than that of the threshold resistor R, the judging potential Vp is at a low potential level "L". The resistor R can then be used as a threshold element, which is called "threshold resistor R".

The provision of the threshold resistor R brings a significant advantage. When for example, the threshold resistance R is determined at 10 K-ohms and the fuse has blown, then the high potential "H" is applied to the input terminal of the inverter INV until the value of the fuse resistance $R_F$ becomes equal to 10 K-ohms. Accordingly, though the fuse or the gap between the fuse terminals may be contaminated or moisted and lead to a grown-back fuse, the high potential "H" is held stably until the fuse resistance $R_F$ becomes smaller than 10 K-ohms. So, the output level of the fuse circuit indicates whether the fuse has been blown ("H") or unblown("L") and it is possible to judge the fuse condition without error. Moreover, by using the threshold resistor R, it is possible to adjust the fuse resistance $R_F$ to a specified design value without affecting other circuit components. It is a very convenient feature for applying the invention to various IC trimming or controlling circuits.

As has been described above, the fuse circuit of Fig. 2 is obtained by adding a simple circuit FET Tr4, impedance element formed by FET Tr1 and resistor (R) to a conventional fuse circuit (fuse F). Fabrication of such a circuit is easy by applying a conventional IC fabrication process.

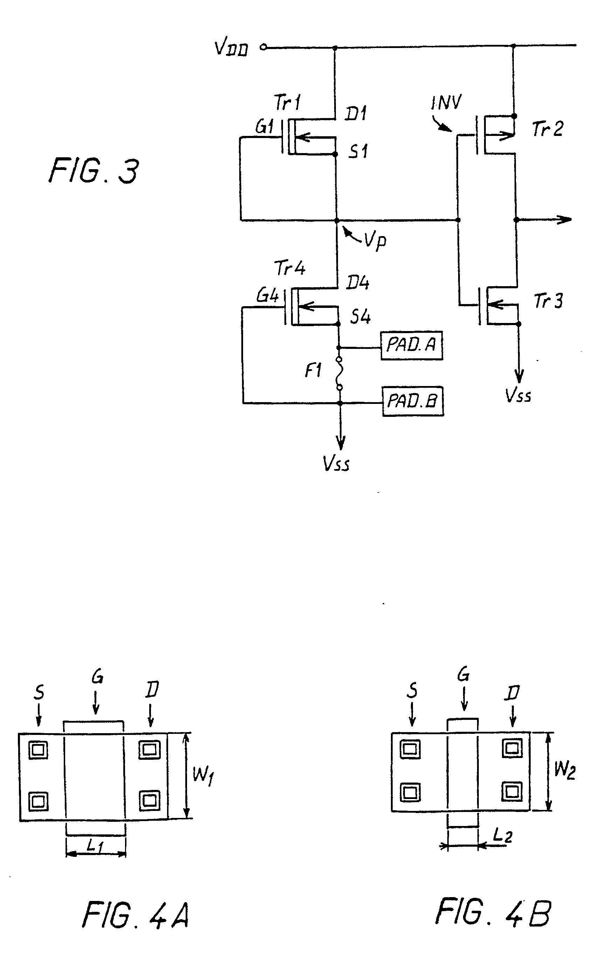

Fig. 3 shows another embodiment of a fuse circuit according to the present invention. Fig. 3 is similar to the circuit of Fig. 2 except that the threshold resistor R is eliminated. In the circuit of Fig. 3, the equivalent resistances of the FETs Tr1 and Tr4 are determined by the size and shape of the respective transistors. By the choice of the on-state resistances of the FETs Tr1 and Tr4, the circuit of Fig. 3 can be considered to be equivalent to that of Fig. 2.

By changing the shape or size of the transistors it is possible to vary their equivalent resistance. For example, Fig. 4A and 4B are partial plan views showing the layout of metal oxide semiconductor field effect transistors (MOSFET) which can be used in the present invention. The internal resistance of the FET is inversely proportional to W/L, the ratio of the width W to the length L of its gate electrode G. In Figs. 4A and 4B, two basic types of the FETs are shown, respectively a FET with a small ratio $W_1/L_1$, and a FET with a large ratio

$W_2/L_2$, so that the on-state resistance of the FET having the pattern shown in Fig. 4A is greater than that of the FET having the pattern shown in Fig. 4B.

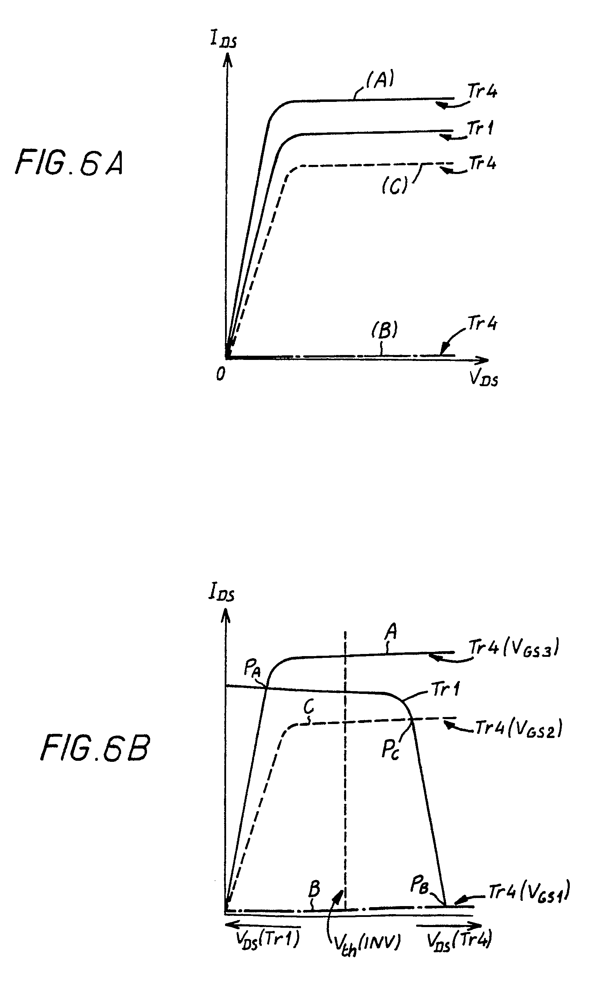

In the circuit of Fig. 3, the FET Tr1 should be formed to have the structure with the small ratio $W_1/L_1$, whilst the FET Tr4 should be formed to have the structure with the large ratio $W_2/L_2$, the reason of such a selection being explained later with respect to Fig. 6 regarding the circuit stability. The judging potential Vp appears on the junction point of the gate G1 of the FET Tr1 and the drain D4 of the FET Tr4. When the fuse is in the unblown state, the judging potential $V_p$ applied to the input of the inverter INV is at a low potential level "L". By contrast, when the fuse has blown, the judging potential Vp reaches a high potential level "H".

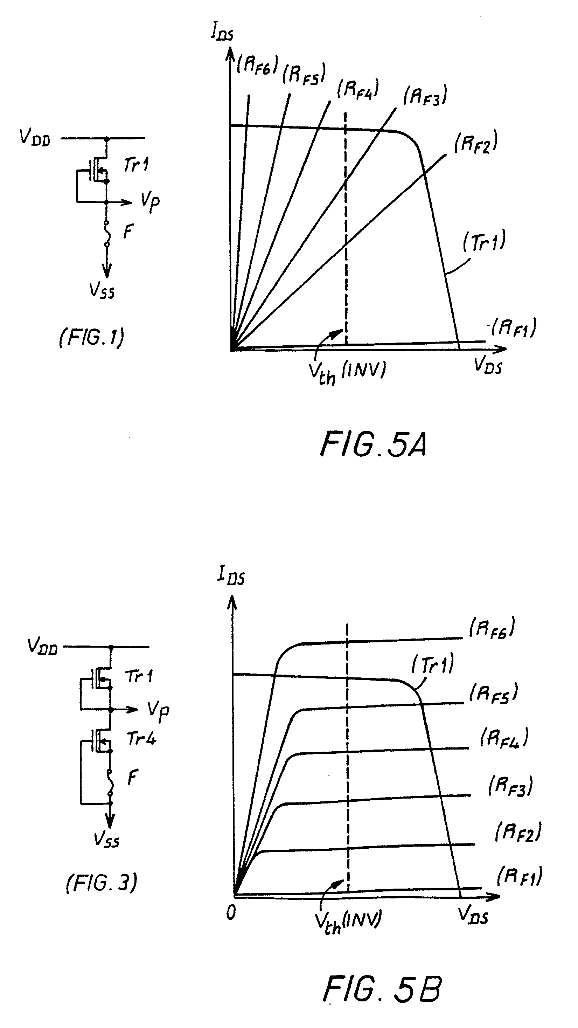

Experimental results will now be described briefly. An FET Tr1 has been used with a gate electrode G1 having a width $W_1$ and length L1 respectively equal to 8 $\mu$m and 20 $\mu$m, so that the W1/L1 ratio was 8/20, $W_2/L_2$ for the FET Tr4 having been selected between 8/18 and 8/16. It has been found that by using FETs having such characteristics, the circuit of Fig. 3 shows a stable operation for a fuse resistance until a few K-ohms after blowing. An IC using such a fuse circuit can then operate without suffering from an erroneous judgement of the fuse condition. The reason of this stability will be described later with respect to Fig. 5 and Fig. 6.

With the embodiment of Fig. 3, the equivalent resistance of the FETs Tr1 and Tr4, and hence the judging potential Vp are determined by the relative ratio of the on-state resistances of the FETs, this ratio being the ratio of the W/L of the two FETs ($W_1/L_1$: $W_2/L_2$). Therefore, the threshold resistor R of the embodiment of Fig. 2, is not necessary and the fabrication process is simplified because the FETs Tr1 and Tr4 can be fabricated simultaneously with other transistors in the IC, and there is no need to add a process step for fabricating the resistances.

Now the circuit stability will be discussed. Fig. 5A is a graph showing the voltage-current characteristic of the FET Tr1 and lines representative of different fuse resistances corresponding to different respective fuse conditions, in the case of the prior art circuit shown in Fig. 1. The horizontal line (X-axis) is the drain-source voltage $V_{DS}$, and the vertical line (Y-axis) is the drain-source current $I_{DS}$, the curve (Tr1) representative of the voltage-current characteristic being then reversed. The inverter input threshold voltage $V_{th}$ (INV) is shown by a vertical-dot line at coordinate $V_{th}$ along the X-axis. So, on the left hand side of the voltage $V_{th}$(INV) is the zone of low potential level "L", and on the right hand side is the zone of high potential level "H". Lines $(R_{F1})...(R_{F6})$ are representative of different values $R_{F1}...R_{F6}$ of the parameter consisting in the resistance $R_F$ of the fuse F, with :

$$R_{F6} < R_{F5} < R_{F4} < R_{F3} < R_{F2} < R_{F1} \quad (1)$$

where line $R_{F1}$ corresponds to the blown state of the fuse, lines $R_{F2}$, $R_{F3}$, $R_{F4}$ and $R_{F5}$ correspond to a grown-back fuse state, and line $R_{F6}$ corresponds to the unblown (conductive) state of the fuse. The cross points of these lines and curve indicate the values of the judging potential Vp of the fuse circuit for the different conditions. As can be seen in Fig. 5A, when the resistance $R_F$ of fuse F becomes smaller than that of the fuse at blown state, the judging potential Vp is reduced from "H" to "L" crossing the inverter threshold voltage $V_{th}$, with, in this example the cross points of the $(R_{F4})$ and $(R_{F5})$ lines with the curve (Tr1) being at low potential level "L", indicating a conductive state. Therefore, the prior art fuse circuit of Fig. 1 operates wrongly, and the associated trimming circuit is out of control.

Fig. 5B is a graph showing the curve (Tr1) representative of the voltage-current characteristic of the FET Tr1 and lines $(R_{F1})...(R_{F6})$ representative of different fuse resistances $R_{F1}...R_{F6}$ corresponding to different fuse conditions in the circuit of Fig. 3. As can be seen in this figure, if the resistance $R_F$ of fuse F becomes smaller than that of the fuse at blown state, the judging potential Vp is held in the high potential level "H" due to the non-linearity of the characteristics of the FET Tr4. For example, though the cross points of the $(R_{F4})$ and $(R_{F5})$ lines with the curve (Tr1) correspond to a grown-back fuse state, the judging potential Vp is still at the high potential level "H", which is a level higher than that of the inverter threshold voltage $V_{th}$(INV). As a result, the fuse circuit of the present invention operates with high accuracy.

Fig. 6A is a graph showing curves representative of voltage-current characteristics of the FETs Tr1 and Tr4 of the circuit of Fig. 3. In this figure, the horizontal line (X-axis) is the drain-source voltage $V_{DS}$, and the vertical line (Y-axis) is the drain-source current $I_{DS}$. When the fuse is in the unblown state, the drain-source current $I_{DS}$ of the FET Tr4 is larger than that of the FET Tr1, and the fuse F has a resistance $R_F$ smaller than those of the FETs. The voltage-current characteristics of the FET Tr4 varies as a function of the fuse condition. The curve (A) shows the state when the fuse F is unblown and in conductive condition, the curve (B) shows the state when the fuse F has been blown, and the curve (C) shows the state when the fuse F is in a "grown-back fuse" condition.

Fig. 6B is a graph for illustrating the stability of operating-point. This graph is composed of the curves representative of the voltage-current characteristics of the FETs Tr1 and Tr4, as in Fig. 6A, but with the curve relative to Tr1 being reversed with respect to Fig. 6A.

The sum of the voltages between source and drain of the FET Tr1 and between source and drain of FET Tr4 can be expressed as :

$$V_{DS}(Tr1) + V_{DS}(Tr4) \quad (2)$$

This sum is equal to the supply voltage $(V_{DD} - V_{SS})$ minus the voltage drop through the fuse $(I_D \times R_F)$, namely,

$$V_{DS}(Tr1) + V_{DS}(Tr4) = (V_{DD} - V_{ss}) - (I_D \times R_F) \quad (3)$$

As mentioned before, the circuit is operated in constant current mode, and the right hand side of equation (3) is considered as constant. The FETs Tr1 and Tr4 are considered to be a load for each other, so that the relation given by the equation (3) can be illustrated as shown in Fig. 6B. Curves (A), (B), (C) in Fig. 6B correspond to three different values $V_{GS3}$, $V_{GS2}$ and $V_{GS1}$ of the potential difference $V_{GS}$ for the FET Tr4, with :

$$V_{GS} = V_{G4} - V_{S4} \quad (4)$$

where $V_{G4}$ and $V_{S4}$ are the potentials at the gate G4 and source S4, respectively, and with :

$$V_{GS1} < V_{GS2} < V_{GS3} \quad (5)$$

The cross points $P_A$, $P_B$ and $P_C$ of curves (A), (B), (C) with the curve representative of the voltage-current characteristic of FET Tr1 indicate the operating points of the FETs for the cases when the fuse is in the unblown, blown and grown-back fuse state, respectively. At the operating point $P_A$, the drain-source current $I_{DS}$ (Tr1) of the FET Tr1 is equal to that of the FET Tr4, this being expressed as :

$$I_{DS}(Tr1) = I_{DS}(Tr4) \quad (6)$$

From the above equation, the internal resistances of the FETs at the operating point can be determined. This can be used for determining the W/L ratio of these FETs. As can be seen in Fig. 6B, the voltage at the point $P_A$ is a low voltage, indicating that the fuse is in the unblown state. The point $P_B$ is at a high potential level "H" indicating that the fuse is in the blown state. If the fuse is in the grown-back fuse state, the operating point shifts to the point P_C, and, even at this point the judge potential Vp is still at high potential level "H". By contrast, assuming that the resistance R_F of the fuse F in the prior art circuit of Fig. 1 , when in the grown-back fuse state, is equal to one Mohm, the judging potential Vp will be lower than half of the supply voltage $V_{DD}-V_{SS}$, i.e. less than the threshold voltage $V_{th}$ of the inverter INV, so that the fuse is judged to be in the unblown state.

It will be understood from Fig. 6B that it is necessary for the FET Tr1 to have a saturation current smaller than that of the FET Tr4. If the saturation current of the FET Tr1 is larger than that of the FET Tr4, the operation point P_A will be shifted to the right hand side of the figure, causing the judging potential Vp to come to the high potential level "H".

In the above disclosed embodiments of the invention, n-channel depletion FETs are used, but it will be clear for anyone with ordinary skill in the art that p-channel FETs, or enhancement type FETs may be used.

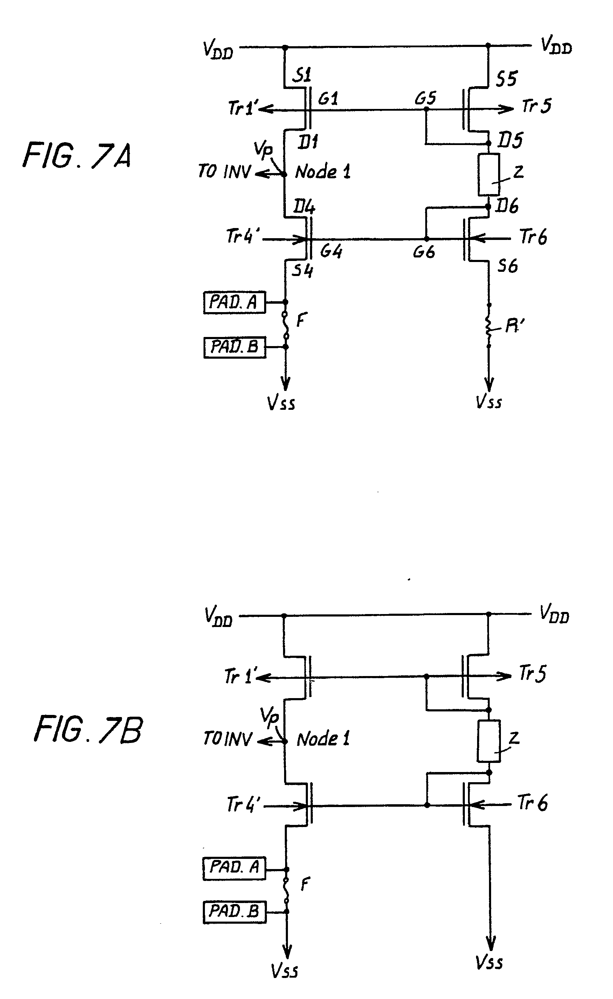

Fig. 7A and 7B show still another embodiment of a fuse circuit according to the present invention applied to a CMOS circuit. The circuit of Fig. 7A has a function similar to that of the circuit of Fig. 2, and the circuit of Fig. 7B has a function similar to that of the circuit of Fig. 3. In Fig. 7A, in order to provide a constant current supply source, a first enhancement type p-channel Tr1', a first enhancement type n-channel FET Tr4' and a fuse F are connected in series between the positive voltage source ($V_{DD}$) and the negative voltage source ($V_{SS}$). An output terminal (NODE 1) is provided at the junction point between the drain D1 of the first FET Tr1' and the drain D4 of the first n-channel FET Tr4'. Similarly, a second enhancement type p-channel FET Tr5, an impedance element Z (transistor or resistor), a second enhancement type n-channel FET Tr6 and a threshold resistor R' are connected in series between the positive voltage source ($V_{DD}$) and the negative voltage source ($V_{SS}$), to form a reference voltage supply circuit (with the gate G5 of the second p-channel FET Tr5 being connected to the drain D5 of Tr5, and to the gate G1 of the first p-channel FET Tr1', and similarly, with the gate G6 of the second n-channel FET Tr6 being connected to the drain D6 of Tr6 and to the gate G4 of the first n-channel FET Tr4'.

In the embodiment of Fig. 7A, the FETs Tr1', and Tr4' are enhancement type FETs with a constant potential applied to their respective gates. In order to follow the variations of the resistance R_F of the fuse F, the constant voltages are applied to the gate G1 of the first p-channel FET Tr1' and to the gate G4 of the first n-channel FET Tr4' from the reference voltage supply circuit(Tr5, Tr6, Z, R').

When the resistance R_F of the fuse F is equal to that of the resistor R', and when the threshold voltage of the inverter INV, which receives the output voltage at NODE 1 is equal to $(V_{DD} + V_{SS})/2$ the resistance of the resistor R' can be used as threshold value for the resistance R_F of fuse F.

In Fig. 7B, the fuse circuit is similar to the one of Fig. 7A except that resistor R' is omitted. In this case, the ratio W1/L1 of the first p-channel FET Tr1' is equal to the ratio W2/L2 of the second p-channel FET Tr5, the first n-channel FET Tr4' is larger than the second n-channel FET Tr6, and a resistor is used as an impedance element Z. Under such conditions a combination circuit can be provided showing the required relative ratio between the on-state resistances of the transistors, for example Tr1'/Tr5<Tr4'/Tr6.

It is to be noted that the on-state resistance of the FETs can be varied not only by varying the ratio W/L but also by other methods.

It is also to be noted that, as already mentioned, the components used in the above disclosed embodiments, (impedance elements such as transistors, resistors and fuse) are all well known and conventional, and may be fabricated on an IC die or chip by any conventional fabrication method for semiconductor devices.

## Claims

1. Integrated circuit having a fuse (F) and an impedance element means (Tr1), serially connected between first and second power supply means for supplying respectively a first voltage ($V_{DD}$) and a second voltage ($V_{SS}$) and providing at a point between the fuse (F) and the impedance element means (Tr1) a judging potential ($V_p$) for judging whether the fuse has blown or not, characterized by a first transistor (Tr4) realising the connection between said fuse (F) and said point supplying said judging potential ($V_p$), and having a source connected to said fuse (F) and a drain connected to said point supplying said judging potential ($V_p$); and a gate biased so that a potential difference between the source and the gate is dependent on a voltage drop across the fuse (F) when the fuse (F) is in a grown-back fuse condition.

2. Integrated circuit according to claim 1, characterized in that said first transistor (Tr4) is a depletion type transistor.

3. Integrated circuit according to any one of claims 1 and 2, characterized in that said impedance element means comprises a second transistor (Tr1) having a constant current characteristic, said second transistor having a gate, a source and a drain.

4. Integrated circuit as claimed in claim 3, characterized in that said impedance element means further comprises a resistor (R) connected between the gate and the source of said second transistor (Tr1), and said potential $(V_p)$ is generated at the junction point between said resistor (R) and the drain of the first transistor (Tr4).

5. Integrated circuit according to claim 4, characterized in that the resistance of the resistor (R) is equivalent to that of the fuse (F) in the unblown condition.

6. Integrated circuit according to any one of claims 3 to 5, characterized in that the second transistor (Tr1) is a depletion type transistor.

7. Integrated circuit according to any one of claims 3 to 6, characterized in that the saturation current of the second transistor (Tr1) is lower than that of the first transistor (Tr4).

8. Integrated circuit according to claim 3, characterized in that the ratio W/L of the first transistor (Tr4) is larger than that of the second transistor (Tr1), where W is the channel width and L is the channel length of the gate electrode of each transistor.

9. Integrated circuit according to any one of the preceding claims, characterized in that the gate of said first transistor (Tr4) is connected to the second power supply means.

10. Integrated circuit according to claim 1, characterized in that said first transistor is an enhancement type transistor having a gate to which a constant potential is applied.

**Revendications**

1. Circuit intégré possédant un fusible (F) et un moyen constituant un élément d'impédance (Tr1), connectés en série entre des premier et deuxième moyens d'alimentation électrique servant à fournir respectivement une première tension $(V_{DD})$ et une deuxième tension $(V_{SS})$ et à produire, en un point situé entre le fusible (F) et le moyen constituant un élément d'impédance (Tr1), un potentiel de décision $(V_p)$ servant à déterminer si le fusible a ou non fondu, caractérisé par un premier transistor (Tr4) réalisant la connexion entre ledit fusible (F) et ledit point fournissant ledit potentiel de décision $(V_p)$, et ayant sa source connectée audit fusible (F) et son drain connecté audit point fournissant ledit potentiel de décision $(V_p)$; et sa grille étant polarisée de façon que la différence de potentiel entre la source et la grille dépende de la chute de tension aux bornes du fusible (F) lorsque le fusible (F) est dans un état de fusible régénéré.

2. Circuit intégré selon la revendication 1, caractérisé en ce que ledit premier transistor (Tr4) est un transistor du type appauvrissement.

3. Circuit intégré selon l'une quelconque des revendications 1 et 2, caractérisé en ce que ledit moyen constituant un élément d'impédance comprend un deuxième transistor (Tr1) possédant une caractéristique de courant constant, ledit deuxième transistor ayant une grille, une source et un drain.

4. Circuit intégré selon la revendication 3, caractérisé en ce que ledit moyen constituant un élément d'impédance comprend en outre une résistance (R) connectée entre la grille et la source dudit deuxième transistor (Tr1), et ledit potentiel $(V_p)$ est produit sur le point de jonction entre ladite résistance (R) et le drain du premier transistor (Tr4).

5. Circuit intégré selon la revendication 4, caractérisé en ce que la valeur de la résistance (R) est équivalente à celle du fusible (F) dans l'état non fondu.

6. Circuit intégré selon l'une quelconque des revendications 3 à 5, caractérisé en ce que le deuxième transistor (Tr1) est un transistor du type appauvrissement.

7. Circuit intégré selon l'une quelconque des revendications 3 à 6, caractérisé en ce que le courant de saturation du deuxième transistor (Tr1) est plus petit que celui du premier transistor (Tr4).

8. Circuit intégré selon la revendication 3, caractérisé en ce que le rapport W/L du premier transistor (Tr4) est plus grand que celui du deuxième transistor (Tr1), où W est la largeur de canal et L est la longueur de canal de l'électrode de grille de chaque transistor.

9. Circuit intégré selon l'une quelconque des revendications précédentes, caractérisé en ce que la grille dudit premier transistor (Tr4) est connectée au deuxième moyen d'alimentation électrique.

10. Circuit intégré selon la revendication 1, caractérisé en ce que ledit premier transistor est un transistor du type enrichissement possédant une grille à laquelle un potentiel constant est appliqué.

**Patentansprüche**

1. Integrierte Schaltung mit einer Sicherung (F) und einer Impedanzelementeinrichtung (Tr1), die in Reihe zwischen ersten und zweiten Energieversorgungseinrichtungen, zum Liefern einer ersten Spannung ($V_{DD}$) bzw. einer zweiten Spannung ($V_{SS}$), angeschlossen ist und an einen Punkt zwischen der Sicherung (F) und der Impedanzelementeinrichtung (Tr1) ein Beurteilungspotential ($V_p$) liefert, um zu beurteilen, ob die Sicherung durchgebrannt ist oder nicht, gekennzeichnet durch einen ersten Transistor (Tr4), der die Verbindung zwischen der genannten Sicherung (F) und dem genannten Punkt realisiert, der das genannte Beurteilungspotential ($V_p$) liefert, und eine Source hat, die mit der genannten Sicherung (F) verbunden ist, und ein Drain, das mit dem genannten das Beurteilungspotential ($V_p$) liefernden Punkt verbunden ist; und ein Gate, welches so vorgespannt ist, daß eine Potentialdifferenz zwischen Source und Gate von einem Spannungsabfall quer an der Sicherung (F) abhängig ist, wenn die Sicherung (F) sich in einem zurückgewachsenen Sicherungszustand befindet.

2. Integrierte Schaltung nach Anspruch 1, dadurch gekennzeichnet, daß der genannte erste Transistor (Tr4) ein Verarmungstyptransistor ist.

3. Integrierte Schaltung nach einem der Ansprüche 1 oder 2, dadurch gekennzeichnet, daß die genannte Impedanzelementeinrichtung einen zweiten Transistor (Tr1) umfaßt, der eine Konstantstromcharakteristik hat, welcher zweite Transistor ein Gate, eine Source und ein Drain hat.

4. Integrierte Schaltung nach Anspruch 3, dadurch gekennzeichnet, daß die genannte Impedanzelementeinrichtung ferner einen Widerstand (R) umfaßt, der zwischen dem Gate und der Source des genannten zweiten Transistors (Tr1) verbunden ist, und das genannte Potential ($V_p$) bei dem Verbindungspunkt zwischen dem genannten Widerstand (R) und dem Drain des ersten Transistors (Tr4) erzeugt wird.

5. Integrierte Schaltung nach Anspruch 4, dadurch gekennzeichnet, daß der Widerstandswert des Widerstandes (R) equivalent zu jenem der Sicherung (F) in nicht durchgebranntem Zustand ist.

6. Integrierte Schaltung nach einem der Ansprüche 3 bis 5, dadurch gekennzeichnet, daß der zweite Transistor (Tr1) ein Verarmungstyptransistor ist.

7. Integrierte Schaltung nach einem der Ansprüche 3 bis 6, dadurch gekennzeichnet, daß der Sättigungsstrom des zweiten Transistors (Tr1) niedriger als jener des ersten Transistors (Tr4) ist.

8. Integrierte Schaltung nach Anspruch 3, dadurch gekennzeichnet, daß das Verhältnis W/L des ersten Transistros (Tr4) größer als jenes des zweiten Transistors (Tr1) ist, wobei W die Kanalbreite und L die Kanallänge der Gateelektrode von jedem Transistor sind.

9. Integrierte Schaltung nach einem der vorhergehenden Ansprüche, dadurch gekennzeichnet, daß das Gate des genannten ersten Transistors (Tr4) mit der zweiten Energieversorgungseinrichtung verbunden ist.

10. Integrierte Schaltung nach Anspruch 1, dadurch gekennzeichnet, daß der genannte erste Transistor ein Anreicherungstyptransistor ist, der ein Gate hat, welchem ein konstantes Potential zugeführt wird.

FIG. 1
(Prior Art)

FIG. 2

FIG. 3

FIG. 4A

FIG. 4B

(FIG.1)

*FIG.5A*

(FIG.3)

*FIG. 5B*

FIG.6A

FIG.6B

FIG. 7A

FIG. 7B

13